# EUROPÄISCHE PATENTSCHRIFT

(11) **EP 1 256 128 B1**
(45) Veröffentlichungstag und Bekanntmachung des Hinweises auf die Patenterteilung: **03.04.2013**
(21) Anmeldenummer: 01919124.6
(22) Anmeldetag: 02.02.2001
(51) Int. Cl.: H01L 21/50, H03H 9/10

(54) **VERKAPSELUNG FÜR EIN ELEKTRISCHES BAUELEMENT UND VERFAHREN ZUR HERSTELLUNG**
ENCAPSULATION FOR AN ELECTRICAL COMPONENT AND METHOD FOR PRODUCING THE SAME
ENCAPSULAGE D'UN COMPOSANT ELECTRIQUE ET SON PROCEDE DE PRODUCTION

(30) Priorität: 14.02.2000 DE 10006446
(43) Veröffentlichungstag der Anmeldung: 13.11.2002
(73) Patentinhaber: EPCOS AG, 81669 München (DE)
(72) Erfinder: PAHL, Wolfgang, 81379 München (DE); FISCHER, Walter, 81543 München (DE)
(74) Vertreter: Epping - Hermann - Fischer
(86) Internationale Anmeldenummer: PCT/DE2001/000404
(87) Internationale Veröffentlichungsnummer: WO 2001/059827

(56) Entgegenhaltungen:
- EP-A- 0 794 616
- EP-A- 0 805 552
- WO-A-00/00961
- WO-A-97/45955
- US-A- 5 831 369

## Beschreibung

Bei der Herstellung elektrischer und elektronischer Bauelemente aus Wafern kann es bereits im Waferstadium, also vor der Vereinzelung in einzelne Bauelemente, erforderlich sein, auf dem Wafer erzeugte empfindliche Bauelementstrukturen mit einer Abdeckung zu versehen. Diese Abdeckung kann zum einen als Schutz vor äußeren Einflüssen im weiteren Herstellungsprozess dienen oder die Grundlage für bestimmte Gehäusetechnologien bilden. Insbesondere kann eine solche Abdeckung einen mechanischen Schutz gegenüber Kratzern und Stößen, einen hermetischen Schutz gegenüber im weiteren Verarbeitungsverfahren eingesetzten Medien oder einen Schutz gegenüber Verunreinigungen, insbesondere gegen die bei miniaturisierten Bauelementen besonders störenden leitfähigen Partikeln darstellen. Auf der Basis dieser Abdeckung kann das Gehäuse vervollständigt werden, beispielsweise durch Vergießen mit Harz, Umpressen mit Kunststoff, Einbau in ein weiteres Gehäuse etc..

Beispielsweise Oberflächenwellenbauelemente weisen besonders empfindliche Bauelementstrukturen auf, die aus fein strukturierten Leiterbahnen ausgebildete Interdigitalwandler und Reflektoren umfassen können. Diese empfindlichen Strukturen dürfen in der Regel nicht mit den genannten Abdeckungen in Kontakt stehen, da andernfalls die Eigenschaften des entsprechenden Oberflächenwellenbauelementes unzulässig und in nicht reproduzierbarer Weise verändert werden können. Eine Abdeckung dieser Strukturen ist nur durch eine einen Hohlraum über den Strukturen ausbildende Verkapselung möglich.

Aus der Offenlegungsschrift EP-A-0 805 552 ist eine Verkapselung eines mit akustischen Wellen arbeitenden Filter sowie eine zugehörige Herstellungsmethode bekannt. Auf einem Wafer ist eine Struktur aus lichtempfindlichem Kunstharz angeordnet, die die Funktionselemente des Filterelemts einschliesst und höher ist als die Filterelemente. Eine Kappe, die vorzugsweise ein zweiter Wafer ist und aus verschiedenen Materialien bestehen kann, wird auf diese Struktur aufgebracht und durch Anpressen kraftschlüssig verbunden. Dazu wird auf der Oberfläche des zweiten Wafers eine dichtende Schicht z.B. eine Thermoplastschicht aufgebracht. Dadurch, dass die umgebende Struktur höher ist als die Filterelemente, entsteht zwischen den Filterelementen und dem abdeckenden zweiten Wafer ein abgedichteter Hohlraum.

In der Offenlegungsschrift EP-A-0 794 616 ist eine Verkapselung eines elektronischen Bauteils, insbesondere eines SAW-Filters, und eine Methode zu dessen Herstellung offenbart. Für eine hermetische Abdichtung des Bauelements mit Hohlraum über dem Bauelement wird um dieses eine Stützstruktur aus Kunstharz auf das Substrat angeordnet. Diese Stützstruktur ist höher, als das Bauelement. Eine Kappe wird so hergestellt, dass sie das Bauelement überdeckt, zu diesem einen ausreichenden Abstand einhält und zusammen mit der Stützstruktur das Bauelement hermetisch isoliert. Diese Kappe wird vorzugsweise separat als lichtempfindliches Kunstharz ausgeführt und mittles photolithografischer Prozesse an die Form des Bauelements bzw. an die Form den Verlauf der Stützstruktur angepasst. Nach dem Aushärten der Kappe wird sie mittels Druck und Erhitzen kraftschlüssig mit der Stützstruktur verbunden.

Aus der WO 95/30 276 ist eine Verkapselung für elektrische und elektronische Bauelemente bekannt, die aus einer die Bauelementstrukturen umschließenden Rahmen- und Stützstruktur und einer darauf aufliegenden Abdeckschicht besteht, welche mit dem Rahmen zusammen eine die empfindlichen Strukturen umschließende hermetisch dicht schließende Kappe ausbilden kann. Sowohl Rahmenstruktur als auch Abdeckschicht werden dabei vorzugsweise aus Photoresistmaterial und insbesondere aus Photoresistfolien hergestellt. Dazu werden diese ganzflächig auflaminiert, über eine Maske belichtet und entwickelt. Diese Schritte sind für Rahmenstruktur und Abdeckschicht separat durchzuführen. Insgesamt ist das Verfahren relativ aufwendig und erfordert eine Vielzahl von Verfahrensschritten.

Aufgabe der vorliegenden Erfindung ist es daher, ein Verfahren zur Verkapselung empfindlicher Bauelementstrukturen anzugeben, welches einfacher durchzuführen ist und dennoch zu einer sicheren Verkapselung auch empfindlicher Bauelementstrukturen führt.

Diese Aufgabe wird erfindungsgemäß durch ein Verfahren nach Anspruch 1 gelöst. Vorteilhafte Ausgestaltungen der Erfindung sowie eine so hergestellte Verkapselung sind weiteren Ansprüchen zu entnehmen.

Das erfindungsgemäße Verfahren geht ebenso wie die eben beschriebene bekannte Verkapselung von einer zweiteiligen Verkapselung aus, nämlich einer die Bauelementstrukturen umschließenden Rahmenstruktur und einer darauf aufsitzenden Dachstruktur. Im Unterschied zum bekannten Verfahren wird erfindungsgemäß jedoch sowohl für die Rahmenstrukturen als auch für die Dachstrukturen ein flüssig aufbringbares Reaktionsharz eingesetzt, welches nachträglich gehärtet wird. Nach Ausbilden der Rahmenstrukturen durch Belichten und Entwickeln einer ersten Reaktionsharzschicht wird darüber ganzflächig, d.h. nicht nur über das einzelne Bauelement sondern ggf. über den gesamten Wafer eine Hilfsfolie gespannt, die sämtliche auf dem Substrat erzeugten Rahmenstrukturen überdeckt und auf diesen fest haftet. Über der Hilfsfolie wird dann die zweite Reaktionsharzschicht strukturiert aufgebracht. Im letzten Schritt werden die außerhalb der Rahmenstrukturen bzw. zwischen den Dachstrukturen frei liegenden Bereiche der Hilfsfolie entfernt, vorzugsweise durch Auflösen mit einem Lösungsmittel oder durch Behandlung mit einem Plasma.

In einer bevorzugten Ausführung der Erfindung wird ein UV-härtbares Reaktionsharz für die zweite Reaktionsharzschicht eingesetzt, welches nach ganzflächiger Aufbringung noch strukturierend belichtet, entwickelt und gehärtet wird.

Von besonderem Vorteil ist dabei, dass das Aufschleudern der flüssigen Reaktionsharze einen einfachen und gut kontrollierbaren Verfahrensschritt darstellt, der einfacher durchzuführen ist als das Auflaminieren von Resistfolien und der insgesamt kostengünstiger ist. Die für die Dachstruktur vorgesehene zweite Reaktionsharzschicht kann dann in einer gewünschten Dicke aufgebracht werden, die eine ausreichende mechanische Stabilität für die Verkapselung gewährleistet. Das Aufbringen weiterer Schichten über dieser Dachstruktur ist dann nicht erforderlich.

Das bildmäßige Belichten von erster und zweiter Reaktionsharzschicht kann dabei jeweils durch Abscannen mit einem Laser, insbesondere mit einem UV-Laser erfolgen. Dies hat den Vorteil, dass der Prozess in einfacher Weise an variierende Bauelementstrukturen angepasst werden kann und nicht erst aufwendig Photomasken für den Belichtungsprozess erzeugt werden müssen.

In,vorteilhafter Weise können parallel zur Herstellung der Rahmenstrukturen in der ersten Reaktionsharzschicht weitere Bauelementstrukturen mit erzeugt werden, insbesondere Dämpfungsstrukturen bei Oberflächenwellenbauelementen. In diesem Fall ist es vorteilhaft, wenn das Material der Reaktionsharzschicht akustisch angepasst ist, also eine geeignete Härte und einen geeigneten Elastizitätsmodul aufweist.

Die Entwicklung der Reaktionsharzschichten erfolgt vorzugsweise mit flüssigem Entwickler, je nach verwendetem Harzsystem mit organischen Lösemitteln oder wässrig-alkalisch.

In einer weiteren Ausführung der Erfindung wird die strukturierte zweite Reaktionsharzschicht durch strukturiertes Aufdrucken auf die Hilsfolie im Bereich über den Rahmenstrukturen und Härtung erzeugt. Als strukturierende Druckverfahren sind Sieb- und Schablonendruck geeignet. Das Aufdrucken ist wegen der Hilfsfolie auch bei geringen Strukturabmessungen der Bauelementstrukturen unkritisch, da die mit der zweiten Reaktionsharzschicht nur die Rahmenstrukturen abgedeckt werden müssen. Dafür reicht die Druckgenauigkeit der genannten Druckverfahren aus, selbst wenn dieses Druckverfahren zur Herstellung der ersten Reaktionsharzschicht nicht geeignet ist.

Als Hilfsfolie kann eine dünne Kunststofffolie und insbesondere eine dünne Thermoplastfolie verwendet werden. Diese hat den Vorteil, dass sie sich leicht aufspannen lässt und damit eine ebene Abdeckung über den Rahmenstrukturen erzeugt. Weiterhin lässt sich die Kunststofffolie gut mit den Rahmenstrukturen verbinden, beispielsweise durch Aufkleben, Aufschmelzen oder Aufschweißen.

Das Material für die Kunststoffolie kann dabei so ausgewählt sein, dass es sich einfach wieder entfernen lässt. Insbesondere kann es gut in einem Lösungsmittel löslich sein, welches zum Entfernen der Kunststofffolie in den Bereichen zwischen den Rahmenstrukturen, die nicht zur Abdeckung durch die Verkapselung vorgesehen sind, dienen kann.

Eine entsprechend dünne Kunststoffolie lässt sich auch leicht in einem Plasma abtragen, insbesondere in einem sauerstoffhaltigen Plasma. Dabei wird die Dicke der zweiten Reaktionsharzschicht ausreichend gewählt, um der bei diesem Abtragungsprozess auch auf die zweite Reaktionsharzschicht einwirkenden Auflösung ausreichend Vorhalt zu geben. Als Material für die Kunststofffolie sind insbesondere Polyamid-, PET- oder Polycarbonatfolien geeignet. Die Dicke der Kunststofffolie wird dabei so gewählt, dass sie einerseits möglichst dünn ist, andererseits aber noch ausreichend tragfähig, um die zweite Reaktionsharzschicht ohne zu großes Durchbiegen zu tragen. Üblicherweise sind Foliendicken in der Gegend von 1 µm ausreichend. Es können aber auch dickere Folien bis ca. 20 µm oder dünnere Folien eingesetzt werden, insbesondere solche von 0,5 bis 5 µm Dicke.

Im Folgenden wird die Erfindung anhand eines Ausführungsbeispiels und der dazu gehörigen neun Figuren näher erläutert.

Die Figuren 1 bis 8 zeigen anhand schematischer Querschnitte durch ein zu verkapselndes Bauelement verschiedene Verfahrensstufen bei der Herstellung der Verkapselung.

Figur 9 zeigt das Bauelement während einer Verfahrensstufe in schematischer Draufsicht.

Im Ausführungsbeispiel wird die Verkapselung aktiver und daher empfindlicher Bauelementstrukturen eines Oberflächenwellenbauelementes beschrieben. Die erläuternden Figuren sind nur schematische Darstellungen und daher nicht maßstabsgetreu.

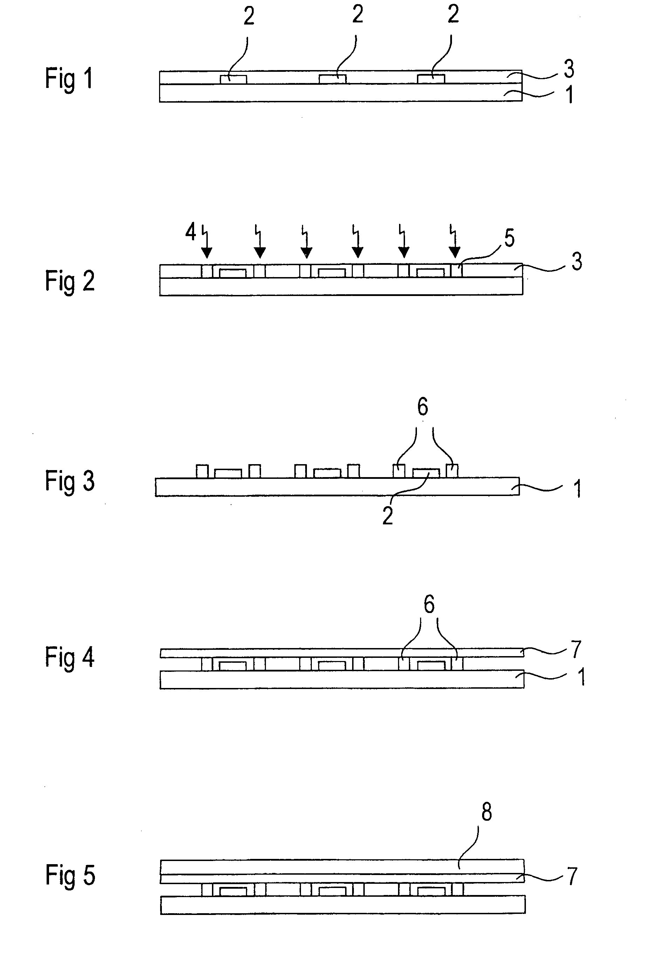

Figur 1 zeigt ein piezoelektrisches Substrat 1, beispielsweise einen Wafer aus Lithiumtantalat oder Lithiumniobat. Auf der Oberfläche des Substrats 1 werden nun verschiedene Bauelementstrukturen aufgebracht, insbesondere elektrisch leitende Strukturen, beispielsweise eine Metallisierung aus Aluminium. In der Figur 1 sind nur Teile dieser Metallisierung schematisch dargestellt, nämlich die empfindlichen Bauelementstrukturen 2, die zwar auf einem Wafer angeordnet sind, aber zu unterschiedlichen Bauelementen gehören können. Auf dem Substrat 1 wird über den Bauelementstrukturen 2 nun ganzflächig eine lichtempfindliche Reaktionsharzschicht 3 aufgeschleudert, beispielsweise in einer Dicke von ca. 50 µm. Die Dicke der Reaktionsharzschicht 3 wird dabei so gewählt, dass sie die Dicke der Bauelementstrukturen 2 so weit übertrifft, so dass die Höhendifferenz zwischen Oberkante der Bauelementstrukturen 2 und der Reaktionsharzschicht 3 einen sicheren Abstand für die Abdeckung der Bauelementstrukturen 2 gewährleistet.

Als Reaktionsharz wird bevorzugt ein kationisch initiiert UV-härtbares und lösungsmittelfreies Epoxidharz aufgebracht, welches unter UV-Strahlung härtbar ist. Neben dem kationisch härtbaren Epoxid enthält dieses Reaktionsharz noch einen Photoinitiator oder ein Photoinitiatorsystem, welches an die Belichtungsquelle angepasst ist. Derartige Epoxidharze sind beispielsweise in der DE-A 44 43 946 beschrieben, auf die hier vollinhaltlich Bezug genommen wird. Zur Unterstützung der Härtung kann das Reaktionsharz noch Zusätze enthalten, die bevorzugt basischer Natur sind und aus der Gruppe salzartiger Hydroxide oder organischer Amine ausgewählt sein können.

Figur 2: Durch scannende Belichtung 4 mit einem UV-Laser werden nun bestimmte Bereiche 5 in der ersten Reaktionsharzschicht 3 belichtet und zumindest angehärtet. Die Belichtung sorgt für einen Löslichkeitsgradienten zwischen belichteten Bereichen 5 und unbelichteten Bereichen der ersten Reaktionsharzschicht 3, die eine Entwicklung mit Hilfe einer Entwicklerlösung erlaubt.

Figur 3 zeigt das Bauelement nach der Entwicklung. Die belichteten und nach dem Entwickeln verbleibenden Bereiche 6 der ursprünglichen ersten Reaktionsharzschicht 3 bilden geschlossene Rahmenstrukturen 6 aus, die die empfindlichen Bauelementstrukturen 2 umschließen. Ggf. kann auf dieser Verfahrensstufe durch kurzzeitige Temperaturerhöhung eine vollständige Härtung der durch den UV-Laser ggf. nur angehärteten Rahmenstrukturen 6 erfolgen. Die vollständige Aushärtung kann auch vor dem Entwickeln erfolgen.

Über die Rahmenstrukturen 6 wird nun eine dünne Kunststofffolie 7 so gespannt, dass sie auf den Rahmenstrukturen 6 dicht aufliegt. Vorzugsweise wird die als Hilfsfolie verwendete Kunststofffolie 7 über das gesamte Substrat 1 gespannt.

Figur 4 zeigt die Anordnung nach dieser Verfahrensstufe. Durch Erhitzen, Verwendung einer mit Kleber beschichteten Folie, durch Laser- oder Reibschweißen oder ähnliche Maßnahmen wird eine haftende Verbindung zwischen der Folie 7 und den Rahmenstrukturen 6 herbeigeführt.

Auf die Hilfsfolie 7 wird anschließend eine Schicht 8 eines ebenfalls lichtempfindlichen flüssigen Reaktionsharzes ganzflächig aufgeschleudert. Vorzugsweise wird das gleiche Harz wie für die erste Reaktionsharzschicht verwendet. Die Dicke dieser zweiten Reaktionsharzschicht 8 wird dabei so gewählt, dass sie erheblich über der Dicke der Kunststofffolie 7 liegt. Figur 5 zeigt die Anordnung nach diesem Verfahrensschritt.

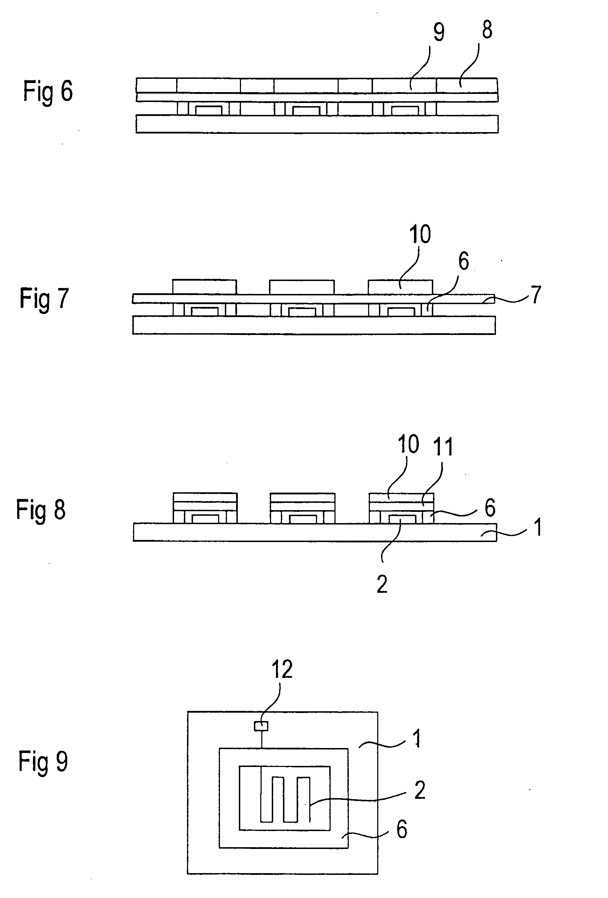

Auch in der zweiten Reaktionsharzschicht 8 wird nun eine strukturierende Belichtung zur Erzeugung gehärteter Bereiche 9 erzeugt, die analog zur Belichtung der ersten Reaktionsharzschicht 3 ebenfalls durch eine scannende UV-Laserbestrahlung vorgenommen wird. Die dabei gehärteten Bereiche 9 sind so angeordnet, dass sie zu den Rahmenstrukturen 6 passende und mit deren äußerem Umfang abschließende Dachstrukturen ausbilden (s. Figur 6).

Figur 7: Ggf. wird nun ein weiterer Temperaturschritt durchgeführt, um die Härtung in den Bereichen 9 zu vervollständigen. Anschließend werden mit einem flüssigen Entwickler, je nach verwendetem Harzsystem mit organischen Lösungsmitteln oder wässrig-alkalisch, die unbelichteten Bereiche der zweiten Reaktionsharzschicht 8 entfernt, wobei die Dachstrukturen 10 verbleiben.

Im nächsten Schritt werden nun die von den Dachstrukturen 10 nicht bedeckten Bereiche der Kunststofffolie 7 entfernt, beispielsweise durch eine kurzzeitige veraschende Behandlung in einem geeigneten, z.B. sauerstoffhaltigen Plasma. Bei diesem Ätzschritt werden die freiliegenden unbedeckten Bereiche der Kunststoffolie 7 vollständig entfernt. Gleichzeitig findet ein teilweiser Schichtabtrag der Dachstrukturen 10 statt. Figur 8 zeigt als Ergebnis die vollständig verkapselte Bauelementstrukturen 2, wobei die Verkapselung aus der Rahmenstruktur 6 und der Dachstruktur 10 mit dazwischen liegenden Resten der Hilfsfolie 11 besteht. Die Bauelementstrukturen 2 sind nun hermetisch versiegelt und beispielsweise gegen weitere aggressive Verfahrensschritte geschützt. Möglich ist es auch, die Bauelemente auf dieser Stufe zu vereinzeln, indem das Substrat 6 zwischen den Bauelementstrukturen bzw. den Verkapselungen zerteilt wird, was beispielsweise durch Sägen erfolgen kann.

Figur 9 zeigt in einer schematischen Draufsicht die Anordnung der Rahmenstrukturen 6 um die empfindlichen Bauelementstrukturen 2, die hier nur schematisch in Form eines Mäanders dargestellt sind. Die empfindlichen Bauelementstrukturen können über Leiterbahnen mit elektrischen Anschlussflächen 12 auf dem Substrat 1 verbunden sein. Die Rahmenstruktur 6 wird dann so angeordnet, dass die empfindlichen Bauelementstrukturen 2 umschlossen sind, die Anschlussflächen 12 ggf. samt Teilen der elektrischen Zuleitungen dafür aber außerhalb der Rahmenstruktur 6 liegen. Ein Teil der elektrischen Zuleitungen wird dabei von der Rahmenstruktur überdeckt. Nach dem Aufbringen der Dachstrukturen 11, 10, die in ihren Außenbegrenzungen mit dem Umfang der Rahmenstrukturen 6 überein stimmen, bleiben dann auch die elektrischen Anschlussflächen 12 zugänglich und können von außen kontaktiert werden. Dies kann beispielsweise durch Flip-Chip-Bonden erfolgen, wobei die Anschlussflächen 12 über sog. Bumps mit einer Basisplatte verbunden werden. Möglich ist es jedoch auch, die Verbindung des Bauelementes über die Anschlussflächen 12 mit Hilfe von Bonddrähten vorzunehmen.

Bevorzugt ist die weitere Verarbeitung mittels Flip-Chip-Bonden, bei der die empfindlichen Bauelementstrukturen auf der zur Basisplatte gewandten Oberfläche des Substrats liegen, und dadurch zusätzlich geschützt werden. Durch zusätzliches Abdichten der Zwischenräume zwischen Substrat 1 und Basisplatte (in der Figur nicht dargestellt) kann das Bauelement weiter versiegelt werden.

Obwohl die Erfindung nur anhand eines Ausführungsbeispiels beschrieben wurde, ist sie nicht auf dieses beschränkt. Vielmehr ist möglich, mit Hilfe der Erfindung auch andere Bauelemente zu verkapseln, wobei auch andere Substratmaterialien, andere Reaktionsharze oder eine andere Art der Belichtung eingesetzt werden können. Die Art des zu verkapselnden Bauelements beziehungsweise der zu verkapselnden Bauelementstrukturen bestimmt dabei auch die geometrische Dimension der Verkapselung, die in weiten Bereichen variiert werden kann.

## Patentansprüche

1. Verfahren zur selektiven Verkapselung empfindlicher Bauelementstrukturen (2) auf elektrischen Bauelementen mit den Schritten in der Reihenfolge:
- a) ganzflächiges Aufschleudern einer flüssigen lichtempfindlichen ersten Reaktionsharzschicht (3) auf die die empfindlichen Bauelementstrukturen aufweisende Oberfläche des Bauelement-Substrates (1)
- b) bildmäßiges Belichten und Entwickeln der ersten Reaktionsharzschicht, wobei eine die Bauelementstrukturen (2) umschließende Rahmenstruktur (6) verbleibt
- c) Aufspannen einer Hilfsfolie (7) über sämtlichen Rahmenstrukturen (6) des Substrats (1)
- d) Erzeugen einer zweiten strukturierten Reaktionsharzschicht (10) auf der Oberfläche der Hilfsfolie im Bereich über der Rahmenstruktur (6) so, daß mit den Rahmen (6) abschließende und mit diesen zusammen einen Hohlraum bildende Dachstrukturen (10) verbleiben
- e) Entfernen der Hilfsfolie (7) in den freiliegenden Bereichen zwischen den Dachstrukturen (10).

2. Verfahren nach Anspruch 1,
bei dem das Erzeugen der zweiten strukturierten Reaktionsharzschicht (8) die folgenden Schritte umfaßt:
- ganzflächiges Aufschleudern einer flüssigen lichtempfindlichen zweiten Reaktionsharzschicht (8) auf die Oberfläche der Hilfsfolie (7)
- bildmäßiges Belichten und Entwickeln der zweiten Reaktionsharzschicht, wobei mit den Rahmen (6) abschließende und mit diesen zusammen einen Hohlraum bildende Dachstrukturen (10) verbleiben.

3. Verfahren nach Anspruch 2,
bei dem das bildmäßige Belichten von erster und/oder zweiter Reaktionsharzschicht (3,8) durch Abscannen mit einem Laser (4) erfolgt.

4. Verfahren nach Anspruch 1 oder 2,
bei dem die Entwicklung der belichteten ersten und/oder der zweiten Reaktionsharzschichten (3,8) mit einem flüssigen Entwickler erfolgt.

5. Verfahren nach Anspruch 1,
bei dem die zweite strukturierte Reaktionsharzschicht (8) mit einem Druckverfahren strukturiert auf die Hilfsfolie (7) aufgebracht wird.

6. Verfahren nach Anspruch 5,
bei dem die Dachstrukturen (10) mit einem Sieb- oder Schablonendruckverfahren aufgebracht und anschließend gehärtet werden.

7. Verfahren nach einem der Ansprüche 1-6,
bei dem als Hilfsfolie (7) eine dünne Kunststofffolie verwendet wird.

8. Verfahren nach einem der Ansprüche 1-7,
bei dem die Hilfsfolie (7) mit den Rahmenstrukturen (6) verklebt oder verschweißt wird.

9. Verfahren nach einem der Ansprüche 1-8,
bei dem das Entfernen der zwischen den Dachstrukturen freiliegenden Hilfsfolie (7) durch eine veraschende Behandlung mit einem Plasma erfolgt.

10. Verfahren nach Anspruch 1-8,
bei dem das Entfernen der zwischen den Dachstrukturen freiliegenden Hilfsfolie (7) durch Behandlung mit einem Lösungsmittel für die Hilfsfolie erfolgt.

11. Verfahren nach einem der Ansprüche 1-10,
bei dem beim bildmäßiges Belichten und Entwickeln der ersten Reaktionsharzschicht (3) zusätzlich zu den Rahmenstrukturen (6) noch Dämpfungsstrukturen herausgebildet werden.

12. Verfahren nach einem der Ansprüche 1-11,
bei dem die Hilfsfolie (7) ausgewählt ist aus Polyamid-, PET- oder Polycarbonatfolie und eine Dicke von 0,5-5 µm aufweist.

13. Verfahren nach einem der Ansprüche 1-12,
bei dem erste und zweite Reaktionsharzschicht (3,8) ein UV-härtbares Epoxidharz umfassen.

14. Verkapselung für ein elektrisches Bauelement mit empfindlichen Bauelementstrukturen (2) auf einem Substrat (1),
- mit einer die empfindlichen Bauelementstrukturen umschließenden Rahmenstruktur (6) aus einem gehärteten Reaktionsharz auf dem Substrat und
- mit einer Kappe, die die Rahmenstruktur (6) abdeckt und mit dieser einen Hohlraum ausbildend abschließt, bestehend aus einer gehärteten Reaktionsharzschicht (10) und einer Kunststofffolie (11) zwischen der gehärteten Reaktionsharzschicht (10) und dem Substrat (1).

15. Verkapselung nach Anspruch 11,
bei der die Kunststofffolie (7) einen Thermoplasten umfasst, ausgewählt aus Polyamid-, PET- oder Polycarbonat.

## Claims

1. Method for selectively encapsulating sensitive component structures (2) on electrical components, comprising the following sequence of steps:
- a) spin-coating a liquid, light-sensitive first reactive resin layer (3) onto the entire surface of the component substrate (1) comprising the sensitive component structures
- b) image exposure and development of the first reactive resin layer, leaving a frame structure (6) that encloses the component structures (2)
- c) stretching an auxiliary film (7) over all the frame structures (6) of the substrate (1)
- d) producing a second structured reactive resin layer (10) on the surface of the auxiliary film in the region above the frame structure (6) so as to leave top structures (10) that finish in line with the frames (6) and together with them form a cavity
- e) removing the auxiliary film (7) in the free regions between the top structures (10).

2. Method according to Claim 1, in which the production of the second structured reactive resin layer (8) comprises the following steps:
- spin-coating a liquid, light-sensitive second reactive resin layer (8) onto the entire surface of the auxiliary film (7)
- image exposure and development of the second reactive resin layer, leaving top structures (10) that finish in line with the frames (6) and together with them form a cavity.

3. Method according to Claim 2, in which the image exposure of the first and/or second reactive resin layer (3, 8) is performed by scanning with a laser (4).

4. Method according to Claim 1 or 2, in which the development of the exposed first and/or second reactive resin layers (3, 8) is performed with a liquid developer.

5. Method according to Claim 1, in which the second structured reactive resin layer (8) is applied in a structured manner to the auxiliary film (7) by a printing process.

6. Method according to Claim 5, in which the top structures (10) are applied by a screen or stencil printing process and are subsequently cured.

7. Method according to one of Claims 1-6, in which a thin film of plastic is used as the auxiliary film (7).

8. Method according to one of Claims 1-7, in which the auxiliary film (7) is adhesively bonded or fused to the frame structures (6).

9. Method according to one of Claims 1-8, in which the removal of the auxiliary film (7) that is free between the top structures is performed by an incinerating treatment with a plasma.

10. Method according to Claims 1-8, in which the removal of the auxiliary film (7) that is free between the top structures is performed by treating with a solvent for the auxiliary film.

11. Method according to one of Claims 1-10, in which, in addition to the frame structures (6), damping structures are formed in the image exposure and development of the first reactive resin layer (3).

12. Method according to one of Claims 1-11, in which the auxiliary film (7) is selected from polyamide, PET or polycarbonate film and has a thickness of 0.5-5 µm.

13. Method according to one of Claims 1-12, in which the first and second reactive resin layers (3, 8) comprise a UV-curable epoxy resin.

14. Encapsulation for an electrical component with sensitive component structures (2) on a substrate (1),
- with a frame structure (6) of a cured reactive resin on the substrate that encloses the sensitive component structures and
- with a cap that covers the frame structure (6) and finishes in line with it, forming a cavity, consisting of a cured reactive resin layer (10) and a film of plastic (11) between the cured reactive resin layer (10) and the substrate (1).

15. Encapsulation according to Claim 11, in which the film of plastic (7) comprises a thermoplastic, selected from polyamide, PET or polycarbonate.

## Revendications

1. Procédé d'encapsulation sélective de structures sensibles (2) de composants sur des composants électriques, le procédé comportant la succession ci-dessous d'étapes :
a) centrifugation d'une première couche (3) de résine réactive liquide et photosensible sur toute la surface du substrat (1) de composants qui présente les structures sensibles de composants,
b) éclairage selon un motif et développement de la première couche de résine réactive en laissant une structure d'encadrement (6) qui entoure les structures (2) de composants,
c) pose d'un film auxiliaire (7) sur la totalité des structures d'encadrement (6) du substrat (1),
d) formation d'une deuxième couche (10) de résine réactive structurée sur la surface du film auxiliaire dans la zone qui surmonte la structure d'encadrement (6) de manière à laisser des structures de toit (10) qui enferment l'encadrement (6) et qui forment avec ce dernier une cavité et
e) enlèvement du film auxiliaire (7) dans les parties libres situées entre les structures de toit (10).

2. Procédé selon la revendication 1, dans lequel la formation de la deuxième couche (8) de résine réactive structurée comporte les étapes suivantes :
centrifugation d'une deuxième couche (8) de résine réactive liquide et photosensible sur toute la surface du film auxiliaire (7) et
éclairage selon un motif et développement de la deuxième couche de résine réactive de manière à laisser des structures de toit (10) qui enferment l'encadrement (6) et qui forment avec ce dernier une cavité.

3. Procédé selon la revendication 2, dans lequel l'éclairage selon un motif de la première et/ou de la deuxième couche (3, 8) de résine réactive s'effectue par balayage par un laser (4).

4. Procédé selon les revendications 1 ou 2, dans lequel le développement de la première et/ou de la deuxième couche (3, 8) de résine réactive s'effectue à l'aide d'un développeur liquide.

5. Procédé selon la revendication 1, dans lequel la deuxième couche (8) de résine réactive structurée est structurée par un procédé d'impression et est appliquée sur le film auxiliaire (7).

6. Procédé selon la revendication 5, dans lequel les structures de toit (10) sont appliquées en recourant à un procédé de sérigraphie ou d'impression au pochoir et sont ensuite durcies.

7. Procédé selon l'une des revendications 1 à 6, qui utilise comme film auxiliaire (7) un mince film en matière synthétique.

8. Procédé selon l'une des revendications 1 à 7, dans lequel le film auxiliaire (7) est collé ou soudé sur les structures d'encadrement (6).

9. Procédé selon l'une des revendications 1 à 8, dans lequel l'enlèvement du film auxiliaire (7) libre entre les structures de toit s'effectue par un traitement de combustion à l'aide d'un plasma.

10. Procédé selon l'une des revendications 1 à 8, dans lequel l'enlèvement du film auxiliaire (7) libre entre les structures de toit s'effectue par traitement par un solvant du film auxiliaire.

11. Procédé selon l'une des revendications 1 à 10, dans lequel des structures de vaporisation sont encore formées en plus des structures d'encadrement (6) lors de l'éclairage selon un motif et le développement de la première couche (3) de résine réactive.

12. Procédé selon l'une des revendications 1 à 11, dans lequel le film auxiliaire (7) est sélectionné parmi les films de polyamide, de PET et de polycarbonate et présente une épaisseur comprise entre 0, 5 et 5 µm.

13. Procédé selon l'une des revendications 1 à 12, dans lequel la première et la deuxième couche (3, 8) de résine réactive comportent une résine époxy durcissable aux UV.

14. Encapsulation pour composants électriques présentant des structures sensibles (2) de composants sur un substrat (1), l'encapsulation présentant :
une structure d'encadrement (6) en résine réactive durcie qui entoure les structures sensibles de composants sur le substrat et
une couverture qui recouvre la structure d'encadrement (6) et qui englobe cette dernière en formant une cavité, la couverture étant constituée d'une couche (10) de résine réactive durcie et d'un film (11) en matière synthétique entre la couche (10) de résine réactive durcie et le substrat (1).

15. Encapsulation selon la revendication 11, dans laquelle le film (7) en matière synthétique comporte un thermoplastique sélectionné parmi le polyamide, le PET ou le polycarbonate.
